# EUROPÄISCHE PATENTSCHRIFT

(11) **EP 3 308 179 B1**
(45) Veröffentlichungstag und Bekanntmachung des Hinweises auf die Patenterteilung: **11.10.2023**
(21) Anmeldenummer: 16728018.9
(22) Anmeldetag: 09.06.2016
(51) Int. Cl.: G01R 31/62, H01H 9/00

(54) **SCHALTVORRICHTUNG, TESTVORRICHTUNG UND VERFAHREN ZUM BETREIBEN EINER SCHALTVORRICHTUNG FÜR EIN MESSGERÄT FÜR EINEN TRANSFORMATOR**
SWITCH APPARATUS, TEST APPARATUS AND METHOD FOR OPERATING A SWITCH APPARATUS FOR A MEASURING DEVICE FOR A TRANSFORMER
DISPOSITIF DE COMMUTATION, DISPOSITIF DE TEST ET PROCÉDÉ POUR FAIRE FONCTIONNER UN DISPOSITIF DE COMMUTATION POUR UN APPAREIL DE MESURE POUR UN TRANSFORMATEUR

(30) Priorität: 15.06.2015 AT 504862015
(43) Veröffentlichungstag der Anmeldung: 18.04.2018
(73) Patentinhaber: Omicron electronics GmbH, 6833 Klaus (AT)
(72) Erfinder: FREIBURG, Michael, 59846 Sundern (DE); FEUSTEL, Felix, 6850 Dornbirn (AT); SCHEDLER, Horst, 6830 Rankweil (AT); ATLAS, Dmitry, 6833 Weiler (AT)
(74) Vertreter: Banzer, Hans-Jörg
(86) Internationale Anmeldenummer: PCT/EP2016/063143
(87) Internationale Veröffentlichungsnummer: WO 2016/202673

(56) Entgegenhaltungen:
- WO-A1-2009/026038
- CN-A- 103 018 576
- CN-U- 204 389 590
- GB-A- 2 411 733
- US-A- 3 083 331
- US-A1- 2014 210 495

## Beschreibung

### GEBIET DER ERFINDUNG

Die Erfindung betrifft eine Schaltvorrichtung für ein Messgerät für einen Transformator, eine Testvorrichtung mit der Schaltvorrichtung und ein Verfahren zum Betreiben der Schaltvorrichtung. Die Erfindung betrifft insbesondere derartige Vorrichtungen und Verfahren, welche für Messgeräte für Spannungswandler einsetzbar sind.

### HINTERGRUND

Transformatoren werden als Bestandteile von Energieversorgungsnetzen verwendet, beispielsweise zur Messung elektrischer Größen hohen Potentials, zum Netzschutz oder zur Spannungswandlung, beispielsweise zur Spannungswandlung von einem ersten Wert an einer Oberspannungsseite zu einem zweiten Wert, der kleiner als der erste Wert ist, an einer Unterspannungsseite.

Zur Messung des Übertragungsverhaltens, beispielsweise zur Gewährleistung der Betriebssicherheit oder aus weiteren Gründen kann die Bestimmung einer Mehrzahl von charakteristischen Kenngrößen des Transformators mittels eines Messgeräts erforderlich sein. Beispiele für derartige Kenngrößen beinhalten die Bestimmung eines Wicklungswiderstands, die Bestimmung eines Übersetzungsverhältnisses und/oder die Bestimmung einer Streuimpedanz oder Streuinduktivität des Transformators. Insbesondere umfasst die Bestimmung der Mehrzahl der Kenngrößen eine Mehrzahl von Einzelmessungen, in welchen jeweils eine elektrische Spannung und/oder ein elektrischer Strom erfasst und ausgewertet wird. Aus den gemessenen Kenngrößen können beispielsweise Rückschlüsse auf die Messgenauigkeit (Mess- oder Schutzklasse) des Transformators gezogen werden.

Ein beispielhaftes Verfahren, mit dem unterschiedliche Parameter von Spannungswandlern bestimmt werden können, ist in EP 2787 357 A2 beschrieben. Auf Basis dieser Parameter kann die Übertragungsgenauigkeit von Spannungswandlern ermittelt werden. Für die Anwendung dieses Verfahrens ist eine hohe Genauigkeit und Reproduzierbarkeit bei der Bestimmung der Parameter erforderlich. Weiterer Stand der Technik findet sich in den Dokumenten GB2411733A und US3083331A.

In der Regel variiert die äußere Beschaltung (Verdrahtungskonfiguration) des zu prüfenden Transformators bei der Mehrzahl der Einzelmessungen, wobei dies insbesondere bei Anwendung eines so genannten Vierdraht- oder Vierleiter-Messverfahrens gilt. Eine manuelle Umverdrahtung kann dabei einen hohen Arbeits- und Zeitaufwand mit sich bringen und zu fehlerhaften, ungenauen oder nicht reproduzierbaren Einzelmessungen führen. Dies gilt insbesondere auch für das Herstellen von Kurzschlüssen auf der Primärseite oder Sekundärseite des jeweiligen Prüflings, wobei derartige Kurzschlüsse abhängig von dem jeweils angewendeten Testverfahren häufig erforderlich sind.

### ZUSAMMENFASSUNG DER ERFINDUNG

Es besteht daher ein Bedarf an Vorrichtungen und Verfahren, welche im Rahmen einer Transformatorprüfung eine automatisierbare Änderung der Verdrahtungskonfiguration zwischen einem Transformator-Messgerät und dem zu prüfenden Transformator bewirken. Es besteht insbesondere ein Bedarf an solchen Vorrichtungen und Verfahren, welche sich für zu prüfende Spannungswandler eignen.

Diese Aufgabe wird erfindungsgemäß durch eine Schaltvorrichtung mit den Merkmalen des Anspruchs 1, eine Testvorrichtung mit den Merkmalen des Anspruchs 11 und ein Verfahren mit den Merkmalen des Anspruchs 14 gelöst. Die abhängigen Ansprüche definieren bevorzugte und/oder vorteilhafte Ausführungsformen der vorliegenden Erfindung.

Erfindungsgemäß werden eine Schaltvorrichtung für ein Messgerät für einen Transformator, eine Testvorrichtung mit der Schaltvorrichtung und ein Verfahren zum Betreiben der Schaltvorrichtung angegeben, welche sich auf steuerbare Schaltmittel stützen, um eine automatisierte Änderung der Verdrahtungskonfiguration zwischen dem Messgerät und dem zu prüfenden Transformator bewirken zu können.

Mit derartigen Vorrichtungen und Verfahren können der Arbeits- und Zeitaufwand sowie insbesondere solche Fehler und Ungenauigkeiten bei Änderungen der Verdrahtungskonfiguration zwischen dem Messgerät und dem zu prüfenden Transformator reduziert werden, welche eine manuelle Verdrahtung bei einer Mehrzahl aufeinanderfolgender Einzelmessungen mit sich bringen kann. Die Messergebnisse können dadurch reproduzierbarer werden, wobei zudem eine erhöhte Genauigkeit beim Test des jeweiligen Transformators erzielt werden kann.

Die vorliegende Erfindung ist bevorzugt für den Betrieb mit Spannungswandlern geeignet. Spannungswandler, auch Messwandler oder Schutzwandler genannt, dienen beispielsweise zum potentialfreien Erfassen von Wechselspannungen für Energiezähler- oder Netzschutzanwendungen. Die Erfindung ist jedoch nicht auf diesen bevorzugten Anwendungsbereich beschränkt. Grundsätzlich kann die Erfindung für jede Transformatorart verwendet werden.

Die Schaltvorrichtung umfasst steuerbare Schaltmittel, welche dazu eingerichtet sind, jeweils zugeordnete Anschlüsse einer aus einer Mehrzahl von Wicklungen des Transformators kurzzuschließen.

Eine Wicklung eines Transformators ist dabei eine Spule, d.h. ein passives Bauelement, welches hauptsächlich durch eine elektrische Induktivität und zudem durch einen ohmschen Widerstand und eine parasitäre Kapazität charakterisierbar ist.

Die Anschlüsse einer Wicklung können Enden und/oder Anzapfungen der Wicklung sein.

Steuerbar bedeutet vorliegend, dass das betreffende Schaltmittel ohne manuellen Eingriff betätigt werden kann. Ein zur Ansteuerung des jeweiligen Schaltmittels vorgesehenes Steuersignal kann gemäß einem bevorzugten Ausführungsbeispiel von dem Messgerät erzeugt werden, so dass über das Messgerät die Verdrahtungskonfiguration automatisch und flexibel an die jeweiligen Bedürfnisse und die jeweils durchzuführenden Testsequenzen angepasst werden kann, wobei das Konfigurieren der Schaltvorrichtung, das Erzeugen und Anlegen des jeweiligen Testsignals sowie das Abgreifen und Auswerten des jeweiligen Messsignals über das Messgerät zentral koordinierbar sind.

Die Schaltvorrichtung umfasst erste weitere steuerbare Schaltmittel, welche dazu eingerichtet sind, einem jeweils zugeordneten Anschluss einer der Mehrzahl der Wicklungen eine von dem Messgerät bereitzustellende erste elektrische Größe als ein Testsignal dem Transformator zuzuführen.

Die erste elektrische Größe kann ein elektrisches Potential oder ein elektrischer Strom sein. Sie kann eine Wechselgröße oder eine konstante Größe sein.

Die Schaltvorrichtung umfasst zweite weitere steuerbare Schaltmittel, welche dazu eingerichtet sind, von einem jeweils zugeordneten Anschluss einer der Mehrzahl der Wicklungen eine durch das Messgerät zu erfassende zweite elektrische Größe als Messsignal abzuführen.

Die zweite elektrische Größe kann ebenso ein elektrisches Potential oder ein elektrischer Strom sowie eine Wechselgröße oder eine konstante Größe sein.

Eine Differenz zwischen zwei elektrischen Potenzialen ist dabei eine elektrische Spannung. Diese kann zwischen zwei Anschlüssen einer betreffenden Wicklung oder einem Anschluss dieser Wicklung und dem Erdpotential anliegen.

Die steuerbaren Schaltmittel können gemäß einer Ausführungsform dazu eingerichtet sein, jeweils zugeordnete Anschlüsse einer sekundärseitigen der Mehrzahl der Wicklungen mit einem ohmschen Widerstand von weniger als 10 Ω, bevorzugt von weniger als 1 Ω und besonders bevorzugt von weniger als 1 mΩ, niederohmig kurzzuschließen. Bei diesem Ausführungsbeispiel entspricht die sekundärseitige Wicklung insbesondere einer Unterspannungsseite des Transformators, welche eine Niederspannung führt.

Die steuerbaren Schaltmittel können zudem bei einer weiteren Ausführungsform dazu eingerichtet sein, jeweils zugeordnete Anschlüsse einer primärseitigen der Mehrzahl der Wicklungen mit einem ohmschen Widerstand von weniger als 50% eines Wicklungswiderstandes derselben, bevorzugt von weniger als 1 Ω und besonders bevorzugt von weniger als 1 mΩ, niederohmig kurzzuschließen. Die primärseitige Wicklung entspricht bei dieser Ausführungsform insbesondere einer eine Hochspannung führenden Oberspannungsseite des Transformators.

Die steuerbaren Schaltmittel können des Weiteren dazu eingerichtet sein, die jeweils zugeordneten Anschlüsse der jeweiligen primären oder sekundären Transformatorwicklung doppelt kurzzuschließen. So kann zur Erhöhung der Zuverlässigkeit und Produktsicherheit der entsprechende Kurzschluss beispielsweise über entsprechende Schaltmittel in einem ersten Modul, insbesondere einem Niederspannungsmodul, und zusätzlich über entsprechende Schaltmittel in einem zweiten Modul, insbesondere einem Hochspannungsmodul, realisiert werden. Somit wird vermieden, dass ein fehlerhafter Kurzschluss gefährliche Potenziale in der Schaltvorrichtung hervorrufen kann.

Bei einer Messung kann der jeweilige Transformator insbesondere als Aufwärtswandler betrieben werden. Aus einigen Volt am Eingang können somit einige Kilovolt an der Primärseite resultieren. Bei fehlerhaftem Kurzschluss liegen entsprechend die Kilovolt an der durch die beschriebenen steuerbaren Schaltmittel gebildeten Schaltmatrix an. Ein dem Kurzschluss parallel geschalteter Transformator mit seinerseits redundantem Kurzschluss auf der "anderen" Seite kann somit den Kurzschluss redundant absichern.

Die einzelnen steuerbaren Schaltmittel können jeweils Leistungsschalter sein.

Leistungsschalter sind spezielle Schalter, welche zum Schalten eines Lastkreises unter Kontrolle eines Steuerkreises eingerichtet sind. Die steuerbaren Schaltmittel können jeweils Hochspannungsrelais, Bipolartransistoren mit isolierter Steuerelektrode (IGBT) oder Feldeffekttransistoren (FET) sein oder diese jeweils umfassen.

Die Mehrzahl der Wicklungen des Transformators kann auch Teilwicklungen umfassen.

Die Schaltvorrichtung kann in das Messgerät integriert sein, so dass die Schaltvorrichtung mit der Testsignal-Signalquelle sowie der Messsignal-Auswertungseinheit des Messgeräts in einem gemeinsamen Gehäuse untergebracht ist.

Die Schaltvorrichtung und das Messgerät können jedoch auch in separaten Gehäusen vorgesehen sein. Die separate Schaltvorrichtung kann im Feldeinsatz insbesondere im Hochspannungsbereich in der Nähe des zu prüfenden Transformators positioniert werden, während das Messgerät im sicheren Bereich außerhalb der Hochspannungsumgebung bedient werden kann.

Eine erfindungsgemäße Testvorrichtung umfasst nach einem Ausführungsbeispiel eine Schaltvorrichtung gemäß einer der zuvor beschriebenen Ausführungsformen und ein Messgerät für einen Transformator.

Ein Verfahren zum Betreiben einer Schaltvorrichtung für ein Messgerät für einen Transformator umfasst nach einem Ausführungsbeispiel ein Kurzschließen von jeweils zugeordneten Anschlüsse einer Wicklung aus einer Mehrzahl von Wicklungen des Transformators mit Hilfe von steuerbaren Schaltmitteln.

Das Verfahren kann mit der Schaltvorrichtung oder der Testvorrichtung nach einem der zuvor beschriebenen Ausführungsbeispiele ausgeführt werden.

Insbesondere können sämtliche oben genannten Merkmale der Schaltvorrichtung demzufolge als analoge Verfahrensmerkmale bei dem Verfahren vorgesehen sein.

Die Vorrichtungen und Verfahren nach Ausführungsbeispielen der Erfindung können wie beschrieben automatisiert unterschiedliche Verdrahtungskonfigurationen zwischen einem Transformator-Messgerät und dem zu prüfenden Transformator bereitstellen. Dabei können verschiedene Vorteile realisiert werden. Insbesondere sind Arbeits- und Zeitaufwand sowie solche Fehler und Ungenauigkeiten bei Änderungen der Verdrahtungskonfiguration zwischen dem Messgerät und dem zu prüfenden Transformator reduzierbar, welche eine manuelle Verdrahtung bei einer Mehrzahl aufeinanderfolgender Einzelmessungen mit sich bringen kann. Die Messergebnisse können dadurch reproduzierbarer werden.

Transformatoren mit einer Vielzahl unterschiedlicher Ausgestaltungen werden in der Praxis eingesetzt. Die Eigenschaften der Transformatoren variieren entsprechend. Die Vorrichtungen und Verfahren nach Ausführungsbeispielen der Erfindung ermöglichen eine einfache Prüfung einer großen Vielfalt von unterschiedlichen Transformatoren mit einer Vielzahl unterschiedlicher Ausgestaltungen, wobei eine weitgehende Automatisierung der Transformatorprüfung möglich ist.

### KURZE BESCHREIBUNG DER FIGUREN

Die Erfindung wird nachfolgend unter Bezugnahme auf die Zeichnungen anhand bevorzugter Ausführungsformen näher erläutert.
Figur 1 zeigt eine Schaltvorrichtung nach einem Ausführungsbeispiel.
Figuren 2A und 2B zeigen beispielhafte Wicklungsanschlüsse eines zu prüfenden Transformators an die Schaltvorrichtung des Ausführungsbeispiels.
Figur 3 zeigt ein Messgerät mit einer darin integrierten Schaltvorrichtung nach einem weiteren Ausführungsbeispiel.
Figur 4 zeigt eine Testvorrichtung nach einem Ausführungsbeispiel.
Figur 5 zeigt ein Flussdiagramm eines Verfahrens nach einem Ausführungsbeispiel.

### DETAILLIERTE BESCHREIBUNG VON AUSFÜHRUNGSBEISPIELEN

Nachfolgend wird die vorliegende Erfindung anhand bevorzugter Ausführungsformen unter Bezugnahme auf die Zeichnungen näher erläutert. In den Figuren bezeichnen gleiche Bezugszeichen gleiche oder ähnliche Elemente. Die Figuren sind schematische Darstellungen verschiedener Ausführungsformen der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und ihr Zweck dem Fachmann verständlich werden.

In den Figuren dargestellte Verbindungen und Kopplungen zwischen funktionellen Einheiten und Elementen können auch als indirekte Verbindung oder Kopplung implementiert werden. Eine Verbindung oder Kopplung kann drahtgebunden oder drahtlos implementiert sein.

Nachfolgend werden Vorrichtungen und Verfahren für einen beliebig ausgestalteten Transformator detailliert beschrieben. Der Transformator kann beispielsweise ein Transformator für Hoch- oder Mittelspannungsnetze sein. Der Transformator kann zudem beispielsweise ein in einem Kraftwerk oder Umspannwerk installierter Transformator sein. Die Vorrichtung kann ein mobiles Gerät sein, welches die Durchführung einer Prüfung vor Ort an einem installierten Transformator erlaubt.

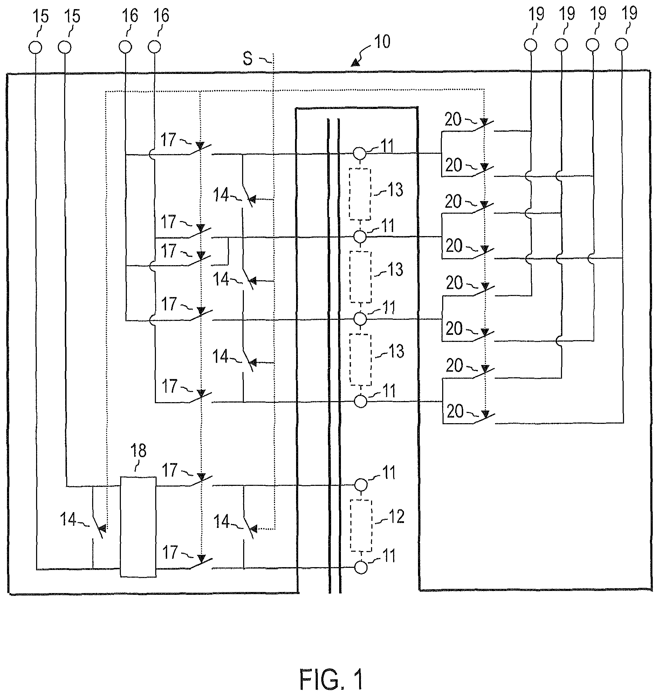

Figur 1 zeigt eine Schaltvorrichtung 10 nach einem Ausführungsbeispiel.

Dabei ist eine Mehrzahl von aus der Schaltvorrichtung 10 herausgeführten Anschlüssen 11 ersichtlich, welche zum Anschließen von Wicklungen eines zu prüfenden Transformators dienen, wobei der Transformator insbesondere ein Spannungswandler sein kann und seine mehreren Wicklungen auch Teilwicklungen sein können.

Das Ausführungsbeispiel umfasst eine Anschlussposition 12 für eine primärseitige Wicklung sowie drei Anschlusspositionen 13 für mehrere gleichzeitig anschließbare sekundärseitige Wicklungen, Alle Wicklungen werden, wie durch die beiden vertikalen Parallelen angedeutet, beispielsweise vom gleichen magnetischen Fluss durchsetzt.

Die Schaltvorrichtung 10 weist auf der linken Seite der Figur 1 steuerbare Schaltmittel 14 auf, welche dazu eingerichtet sind, die jeweils zugeordneten Anschlüsse 11 einer der Mehrzahl der Wicklungen des Transformators kurzzuschließen.

Insbesondere können die steuerbaren Schaltmittel 14 die ihnen jeweils zugeordneten Anschlüsse 11 niederohmig kurzschließen. Während dies für an den Anschlusspositionen 13 angeschlossene sekundärseitige Wicklungen einen ohmschen Widerstand von weniger als 10 Ω, bevorzugt von weniger als 1 Ω und besonders bevorzugt von weniger als 1 mΩ, erfordern kann, ist bei an der Anschlussposition 12 angeschlossenen primärseitigen Wicklungen vorzugsweise ein ohmscher Kurzschlusswiderstand von weniger als 50% des Wicklungswiderstandes derselben, bevorzugt von weniger als 1 Ω und besonders bevorzugt von weniger als 1 mΩ vorzusehen.

Links oben in Figur 1 ist eine Mehrzahl von aus der Schaltvorrichtung 10 herausgeführten Anschlüssen 15, 16 zu erkennen. Über diese sind der Schaltvorrichtung 10 bevorzugt von einem Messgerät bereitzustellende erste elektrische Größen, bei denen es sich insbesondere um Ströme oder elektrische Potenziale handelt, als Testsignale zuführbar. Bei dem dargestellten Ausführungsbeispiel sind dabei die Anschlüsse 15 hochspannungsseitige Anschlüsse, während die Anschlüsse 16 niederspannungsseitige Anschlüsse sind.

In diesem Zusammenhang weist die Schaltvorrichtung 10 erste weitere steuerbare Schaltmittel 17 auf, welche dazu eingerichtet sind, einem jeweils zugeordneten Anschluss 11 einer der Mehrzahl der Wicklungen das an einem jeweiligen Anschluss 15, 16 bereitgestellte Testsignal zuzuführen. Dabei können die Anschlüsse 11 der sekundärseitigen Anschlusspositionen 13 jeweils flexibel mit einem der beiden Anschlüsse 16 verbunden werden.

In Fig. 1 ist zudem ein Block 18 angedeutet, welcher zum Erzeugen eines Hochspannung-Testsignals dient. Dieser Block kann in die Schaltvorrichtung 10 oder in das zugeordnete (und in Fig. 1 nicht gezeigte) Messgerät integriert sein. Ebenso ist jedoch auch möglich, dass es sich bei dem Abschnitt 18 um eine separate Komponente handelt, welche entsprechend mit dem Messgerät und der Schaltvorrichtung 10 zu verbinden ist. Der Block 18 ist sowohl auf der Seite der Anschlüsse 11 als auch aus Sicherheitsgründen auf der Seite der Anschlüsse 15 mit jeweils einem steuerbaren Schaltmittel 14 doppelt kurzschließbar. Demzufolge sind die den primärseitigen Wicklungen zugeordneten Anschlüsse 11 doppelt kurzschließbar.

Rechts oben in Figur 1 ist eine Mehrzahl von aus der Schaltvorrichtung 10 herausgeführten Anschlüssen 19 gezeigt. Über diese können zweite elektrische Größen, welche vorzugsweise ebenfalls Ströme oder elektrische Spannungen sind, aus der Schaltvorrichtung 10 heraus und als Messsignale dem Messgerät zugeführt werden.

Die Schaltvorrichtung 10 umfasst zu diesem Zweck zwischen den Anschlüssen 11 der sekundärseitigen Anschlusspositionen 13 und den Anschlüssen 19 zweite weitere steuerbare Schaltmittel 20, welche dazu eingerichtet sind, einen jeweils zugeordneten Anschluss 11 mit einem jeweils vorgegebenen Anschluss 19 zu verbinden. Durch entsprechende Verschaltung können die Anschlüsse 11 jeweils flexibel mit einem vorgegebenen aus zwei möglichen Anschlüssen 19 verbunden werden.

Die steuerbaren Schaltmittel 14, 17 und 20 können jeweils Leistungsschalter sein.

Wie in Fig. 1 angedeutet ist, sind die einzelnen steuerbaren Schaltmittel 14, 17, 20 durch vorzugsweise von dem Messgerät bereitzustellende Steuersignale S steuerbar. Auf diese Weise können über diese Steuersignale S variabel verschiedene Testkonfigurationen durch Kurzschließen der jeweils erforderlichen Wicklungen des Prüflings an der Schaltvorrichtung 10 eingestellt und die Tessignale den gewünschten primär- oder sekundärseitigen Anschlüssen zugeführt bzw. die Messignale an den gewünschten primär- oder sekundärseitigen Anschlüssen abgegriffen werden.

Die Konfiguration über das Messgerät ist dabei besonders vorteilhaft, da in diesem Fall sowohl die Erzeugung der Testsignale und die Auswertung der Messsignale als auch die Vorgabe der jeweils gewünschten Konfiguration der Schaltvorrichtung 10 mittels der Steuersignale S auf einfache Art und Weise über ein und dieselbe Einheit erfolgt.

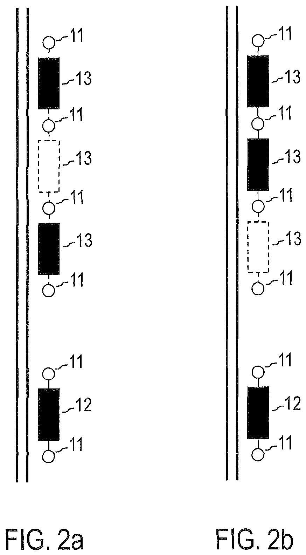

Figuren 2A und 2B zeigen beispielhafte Wicklungsanschlüsse an die Schaltvorrichtung 10 des Ausführungsbeispiels von Fig. 1.

Figur 2A illustriert beispielhafte Wicklungsanschlüsse eines eine primärseitige sowie zwei sekundärseitige Wicklungen aufweisenden Transformators.

Figur 2B stellt ebenfalls beispielhafte Wicklungsanschlüsse eines eine primärseitige sowie zwei sekundärseitige Wicklungen aufweisenden Transformators dar. Die zwei sekundärseitigen Wicklungen dieses Transformators sind tatsächlich Teilwicklungen einer einzelnen sekundärseitigen Wicklung mit einer zwischen den Teilwicklungen vorhandenen Anzapfung. Dementsprechend teilen sich die beiden Teilwicklungen einen gemeinsamen Anschluss 11.

Die Zuordnung der Anschlüsse 11 sowie der steuerbaren Schaltmittel 14, 17 und 20 zu den einzelnen Primär- oder Sekundärwicklungen des jeweiligen Transformators in den in Fig. 1 und Fig. 2 dargestellten Ausführungsformen ist beispielhaft zu verstehen. Selbstverständlich ist die Ausgestaltung der Schaltvorrichtung 10 nicht auf die dargestellten Anwendungsfälle beschränkt. Grundsätzlich können über die steuerbaren Schaltmittel 14 beliebige primär- oder sekundärseitige Anschlüsse des zu testenden Transformators kurzgeschlossen werden. Ebenso können über die steuerbaren Schaltmittel 17 beliebige der Testsignal-Anschlüsse 15, 16 mit beliebigen primär- oder sekundärseitigen Anschlüssen des Transformators verbunden werden, während über die steuerbaren Schaltmittel 20 beliebige der Messsignal-Anschlüsse 19 mit beliebigen primär- oder sekundärseitigen Anschlüssen des Transformators koppelbar sind.

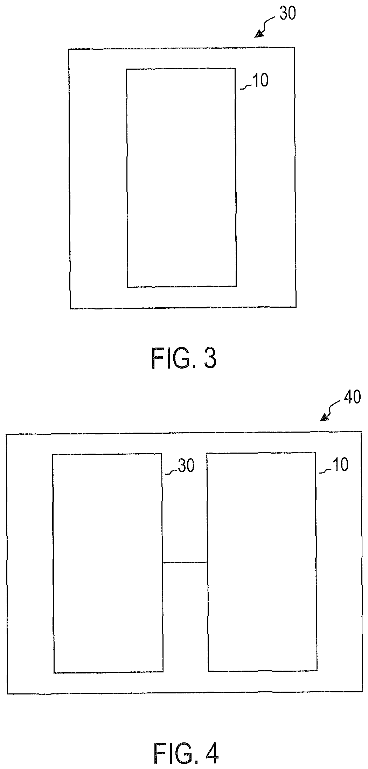

Figur 3 zeigt ein Ausführungsbeispiel, bei dem die Schaltvorrichtung 10 in das zugeordnete Messgerät 30 integriert ist. Bei diesem Ausführungsbeispiel teilen sich das Messgerät 30 und die Schaltvorrichtung 10 somit ein gemeinsames Gehäuse und bilden eine gemeinsame bauliche Einheit. Durch die Gehäuseintegration sind Fehlerquellen und Gefahren bei der Verdrahtung zwischen Messgerät 30 und Schaltvorrichtung 10 vermeidbar.

Figur 4 zeigt eine Testvorrichtung 40 oder Testumgebung nach einem weiteren Ausführungsbeispiel.

Die Testvorrichtung 40 umfasst neben der Schaltvorrichtung 10 das Transformator-Messgerät 30, wobei die Schaltvorrichtung 10 und das Messgerät 30 in jeweils eigenen Gehäusen untergebracht sind und somit separate Einheiten bilden, was für Hochspannungsanwendungen vorteilhaft sein kann. Die separate Schaltvorrichtung 10 ist dann im Feldeinsatz insbesondere im Hochspannungsbereich in der Nähe des zu prüfenden Transformators positionierbar, während das Messgerät 30 im sicheren Bereich außerhalb der Hochspannungsumgebung bedient werden kann.

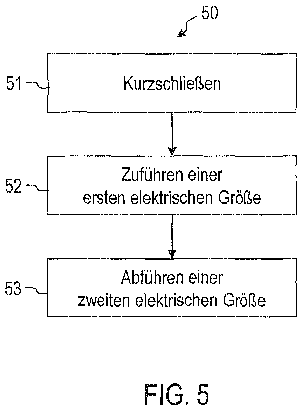

Figur 5 zeigt ein Flussdiagramm eines Verfahrens 50 nach einem Ausführungsbeispiel.

Das Verfahren 50 dient zum Betreiben einer Schaltvorrichtung 10 der zuvor beschriebenen Art mit einem Messgerät 30 für einen Transformator.

Das Verfahren 50 verwendet steuerbare Schaltmittel 14, welche dazu eingerichtet sind, jeweils zugeordnete Anschlüsse 11 einer aus einer Mehrzahl von Wicklungen des Transformators kurzzuschließen. Das Verfahren verwendet ferner erste weitere steuerbare Schaltmittel 17, welche dazu eingerichtet sind, einem jeweils zugeordneten Anschluss 11 einer der Mehrzahl der Wicklungen eine vorzugsweise von dem Messgerät 30 bereitzustellende erste elektrische Größe als Testsignal zuzuführen. Zudem verwendet das Verfahren 50 zweite weitere steuerbare Schaltmittel 20, welche dazu eingerichtet sind, von einem jeweils zugeordneten Anschluss 11 einer der Mehrzahl der Wicklungen eine bevorzugt durch das Messgerät 30 zu erfassende zweite elektrische Größe als Messsignal abzuführen.

Das Verfahren 50 umfasst folgende Schritte. In einem ersten Schritt 51 erfolgt ein Kurzschließen der jeweils zugeordneten Anschlüsse 11 einer aus der Mehrzahl der Wicklungen des Transformators über die steuerbaren Schaltmittel 14. In einem zweiten Schritt 52 erfolgt ein Zuführen der ersten elektrischen Größe als Testsignal an einen jeweils zugeordneten Anschluss 11 einer der Mehrzahl der Wicklungen, nachdem die steuerbaren Schaltmittel 17 entsprechend eingestellt worden sind. In einem dritten Schritt 53 erfolgt ein Abführen oder Abgreifen der zweiten elektrischen Größe als Messsignal von einem jeweils zugeordneten Anschluss 11 einer der Mehrzahl der Wicklungen, nachdem die steuerbaren Schaltmittel 20 entsprechend eingestellt worden sind.

Das Verfahren 50 kann mit jeder Schaltvorrichtung 10 nach einem der zuvor beschriebenen Ausführungsbeispiele oder der Testvorrichtung 40 nach dem obigen Ausführungsbeispiel ausgeführt werden.

Während Ausführungsbeispiele unter Bezugnahme auf die Figuren detailliert beschrieben worden sind, können bei weiteren Ausführungsbeispielen alternative oder zusätzliche Merkmale verwendet werden.

Während beispielsweise die Erfindung mit Bezug auf Spannungswandlern beschrieben worden ist, kann die Erfindung allgemein auf Transformatoren beliebiger Art angewendet werden.

Zudem müssen die steuerbaren Schaltmittel 14, 17 und 20 nicht alle realisiert sein. Der Vorteil der automatisierbaren Konfiguration ist bereits dann erzielbar, wenn lediglich einzelne Schaltmittel der steuerbaren Schaltmittel 14, 17 und 20 vorgesehen sind, um somit einzelne Wicklungsanschlüsse 11 des Prüflings selektiv kurzschließen und/oder selektiv mit einem Testsignal-Ausgang 15, 16 oder einem Messsignal-Eingang 19 des Messgeräts verbinden zu können.

Während der Transformator in einem Kraftwerk oder Umspannwerk eines Energieversorgungsnetzes installiert sein kann, sind die Vorrichtungen und Verfahren nach Ausführungsbeispielen der Erfindung auch bei kleineren Transformatoren einsetzbar.

Die steuerbaren Schaltmittel 14, 17 und 20 und die dadurch realisierte Schaltmatrix können gemäß einer weiteren Ausführungsform auch dazu verwendet werden, mehrere Wicklungen des Prüflings bzw. Transformators, insbesondere mehrere Sekundärwicklungen, seriell zu verschalten. Durch diese Maßnahme kann die Induktivität des Transformators "künstlich" erhöht werden, was wiederum zur Folge hat, dass zur Messung ein geringerer Strom erforderlich ist, so dass eine geringere Ausgangsleistung des Messgeräts und kleiner dimensionierte Schaltmittel (z.B. kleinere Relais) möglich sind.

## Patentansprüche

1. Schaltvorrichtung (10) für ein Messgerät (30) für einen Transformator, umfassend erste steuerbare Schaltmittel (14), welche dazu eingerichtet sind, jeweils zugeordnete Anschlüsse (11) einer Wicklung aus einer Mehrzahl von Wicklungen des Transformators kurzzuschließen, wobei einem der Anschlüsse (11) der Wicklung ein Testsignal von einer Signalquelle des Messgeräts (30) zuzuführen ist, und zweite steuerbare Schaltmittel (14, 17, 20), welche dazu eingerichtet sind, die Wicklung mit einer weiteren Wicklung der Mehrzahl von Wicklungen des Transformators seriell zu verschalten.

2. Schaltvorrichtung gemäß Anspruch 1,
**gekennzeichnet durch**
erste weitere steuerbare Schaltmittel (17), welche dazu eingerichtet sind, dem einen Anschluss (11) der Wicklung eine von dem Messgerät (30) bereitzustellende erste elektrische Größe, insbesondere eine Spannung im Bereich von 0V bis einigen kV, als das Testsignal zuzuführen.

3. Schaltvorrichtung gemäß Anspruch 1 oder Anspruch 2,
**gekennzeichnet durch**
zweite weitere steuerbare Schaltmittel (20), welche dazu eingerichtet sind, von einem jeweils zugeordneten Anschluss (11) einer nochmals weiteren Wicklung der Mehrzahl von Wicklungen eine durch das Messgerät (30) zu erfassende zweite elektrische Größe als ein Messsignal abzuführen.

4. Schaltvorrichtung gemäß Anspruch 2 und Anspruch 3,
**dadurch gekennzeichnet,**
**dass** die ersten und zweiten weiteren steuerbaren Schaltmittel (20) durch ein von dem Messgerät (30) bereitzustellendes Steuersignal steuerbar sind.

5. Schaltvorrichtung gemäß einem der Ansprüche 1 bis 4,
**dadurch gekennzeichnet,**
**dass** die ersten steuerbaren Schaltmittel (14) dazu eingerichtet sind, die zugeordneten Anschlüsse (11) der sekundärseitigen Wicklung der Mehrzahl von Wicklungen mit einem ohmschen Widerstand von weniger als 10 Ω, bevorzugt von weniger als 1 Ω und besonders bevorzugt von weniger als 1 mΩ, kurzzuschließen.

6. Schaltvorrichtung gemäß einem der Ansprüche 1 bis 4,
**dadurch gekennzeichnet,**
**dass** die ersten steuerbaren Schaltmittel (14) dazu eingerichtet sind, die zugeordneten Anschlüsse (11) der primärseitigen Wicklung der Mehrzahl von Wicklungen mit einem ohmschen Widerstand von weniger als 50% eines Wicklungswiderstandes derselben, bevorzugt von weniger als 1 Ω und besonders bevorzugt von weniger als 1 mΩ, kurzzuschließen.

7. Schaltvorrichtung gemäß einem der Ansprüche 1 bis 6,
**dadurch gekennzeichnet,**
**dass** die ersten steuerbaren Schaltmittel (14) ferner dazu eingerichtet sind, die zugeordneten Anschlüsse (11) der einen Wicklung doppelt über einen Transformator kurzzuschließen.

8. Schaltvorrichtung gemäß einem der Ansprüche 1 bis 7,
**dadurch gekennzeichnet,**
**dass** die ersten und zweiten steuerbaren Schaltmittel (14) durch ein von dem Messgerät (30) bereitzustellendes Steuersignal steuerbar sind.

9. Schaltvorrichtung gemäß einem der Ansprüche 1 bis 8,
**dadurch gekennzeichnet,**
**dass** die Mehrzahl von Wicklungen des Transformators mindestens eine Teilwicklung des Transformators umfasst.

10. Schaltvorrichtung gemäß einem der Ansprüche 1 bis 9,
**dadurch gekennzeichnet,**
**dass** die Schaltvorrichtung für einen Betrieb mit einem als Spannungswandler ausgestalteten Transformator eingerichtet ist,
wobei alle steuerbaren Schaltmittel (14) vorzugsweise jeweils Leistungsschalter umfassen.

11. Testvorrichtung zum Testen eines Transformators, umfassend
die Schaltvorrichtung (10) gemäß einem der Ansprüche 1 bis 10, und
das Messgerät (30) für den Transformator.

12. Testvorrichtung gemäß Anspruch 11,
**dadurch gekennzeichnet,**
**dass** das Messgerät (30) derart ausgestaltet ist, dass es das Testsignal erzeugt und der Schaltvorrichtung (10) zuführt, um das Testsignal über die Schaltvorrichtung (10) an den Transformator anzulegen, und
**dass** das Messgerät (30) derart ausgestaltet ist, dass es ein Messsignal des Transformators über die Schaltvorrichtung (10) erhält und auswertet.

13. Testvorrichtung gemäß Anspruch 12,
**dadurch gekennzeichnet,**
**dass** das Messgerät (30) eine Signalquelle zum Erzeugen des Testsignals und eine Auswertungseinheit zum Auswerten des Messsignals umfasst,
wobei die Schaltvorrichtung (10) in das Messgerät (30) integriert ist.

14. Verfahren (50) zum Betreiben einer Schaltvorrichtung (10) für ein Messgerät (30) für einen Transformator, umfassend die Schritte:
Kurzschließen von jeweils zugeordneten Anschlüssen (11) einer Wicklung aus einer Mehrzahl von Wicklungen des Transformators mit Hilfe von ersten steuerbaren Schaltmitteln (14) der Schaltvorrichtung (10), wobei einem der Anschlüsse (11) der Wicklung ein Testsignal von einer Signalquelle des Messgeräts (30) zugeführt wird, und
serielles Verschalten der Wicklung mit einer weiteren Wicklung der Mehrzahl von Wicklungen des Transformators mit Hilfe von zweiten steuerbaren Schaltmitteln (14, 17, 20) der Schaltvorrichtung (10).

15. Verfahren (50) gemäß Anspruch 14,
wobei das Verfahren mit der Schaltvorrichtung (10) nach einem der Ansprüche 2 bis 10 oder der Testvorrichtung (40) nach einem der Ansprüche 11 bis 13 ausgeführt wird.

## Claims

1. A switch apparatus (10) for a measuring device (30) for a transformer, comprising
first controllable switch means (14) which are configured to short-circuit respectively assigned terminals (11) of a winding of a plurality of windings of the transformer, wherein one of the terminals (11) of the winding is to be supplied with a test signal from a signal source of the measuring device (30), and
second controllable switch means (14, 17, 20) configured to connect the winding in series with a further winding of the plurality of windings of the transformer.

2. The switch apparatus according to claim 1,
**characterized by**
first further controllable switch means (17) which are configured to supply to the one terminal (11) of the winding a first electrical magnitude to be provided by the measuring device (30) as the test signal, in particular a voltage in the range from 0V to several kV.

3. The switch apparatus according to claim 1 or claim 2,
**characterized by**
second further controllable switch means (20) which are configured to draw a second electrical magnitude to be detected by the measuring device (30) as a measurement signal from a respectively assigned terminal (11) of yet a further winding of the plurality of windings.

4. The switch apparatus according to claim 2 and claim 3,
**characterized in that**
the first and second further controllable switch means (20) are controllable by a control signal to be provided by the measuring device (30).

5. The switch apparatus according to any one of claims 1 to 4,
**characterized in that**
the first controllable switch means (14) are configured to short-circuit the assigned terminals (11) of the secondary side winding of the plurality of windings with an ohmic resistance of less than 10 Ω, preferably of less than 1 Ω and particularly preferably of less than 1 mΩ.

6. The switch apparatus according to any one of claims 1 to 4,
**characterized in that**
the first controllable switch means (14) are configured to short-circuit the assigned terminals (11) of the primary side winding of the plurality of windings with an ohmic resistance of less than 50% of a winding resistance of the same, preferably of less than 1 Ω and particularly preferably of less than 1 mΩ.

7. The switch apparatus according to any one of claims 1 to 6,
**characterized in that**
the first controllable switch means (14) are further configured to double short-circuit the assigned terminals (11) of the one winding through a transformer.

8. The switch apparatus according to any one of claims 1 to 7,
**characterized in that**
the first and second controllable switch means (14) are controllable by a control signal to be provided by the measuring device (30).

9. The switch apparatus according to any one of claims 1 to 8,
**characterized in that**
the plurality of windings of the transformer comprises at least a partial winding of the transformer.

10. The switch apparatus according to any one of claims 1 to 9,
**characterized in that**
the switch apparatus is configured for operation with a transformer configured as a voltage converter,
wherein all controllable switch means (14) preferably each comprise power switches.

11. A test apparatus for testing a transformer, comprising
the switch apparatus (10) according to any one of claims 1 to 10, and
the measuring device (30) for the transformer.

12. The test apparatus according to claim 11,
**characterized in that**
the measuring device (30) is designed such that it generates the test signal and feeds it to the switch apparatus (10) in order to apply the test signal to the transformer via the switch apparatus (10), and
**in that** the measuring device (30) is configured such that it receives and evaluates a measurement signal of the transformer through the switch apparatus (10).

13. The test apparatus according to claim 12,
**characterized in that**
the measuring device (30) comprises a signal source for generating the test signal and an evaluation unit for evaluating the measurement signal,
wherein the switch apparatus (10) is integrated in the measuring device (30).

14. A method (50) for operating a switch apparatus (10) for a measuring device (30) for a transformer, comprising the steps:
short-circuiting respectively assigned terminals (11) of a winding from a plurality of windings of the transformer with the aid of first controllable switch means (14) of the switch apparatus (10), wherein a test signal from a signal source of the measuring device (30) is supplied to one of the terminals (11) of the winding, and
interconnecting the winding in series with a further winding of the plurality of windings of the transformer with the aid of second controllable switch means (14, 17, 20) of the switch apparatus (10).

15. The method (50) according to claim 14,
wherein the method is performed with the switch apparatus (10) according to any one of claims 2 to 10 or the test apparatus (40) according to any one of claims 11 to 13.

## Revendications

1. Dispositif de commutation (10) pour un appareil de mesure (30) pour un transformateur, comprenant des premiers moyens de commutation (14) commandables, lesquels sont conçus pour court-circuiter des raccords (11) respectivement associés d'un bobinage d'une pluralité de bobinages du transformateur, dans lequel un signal d'essai d'une source de signaux de l'appareil de mesure (30) doit être fourni à l'un des raccords (11) du bobinage, et de seconds moyens de commutation (14, 17, 20) commandables, lesquels sont conçus pour connecter en série le bobinage à un autre bobinage de la pluralité de bobinages du transformateur.

2. Dispositif de commutation selon la revendication 1,
**caractérisé par**
d'autres premiers moyens de commutation (17) commandables, lesquels sont conçus pour fournir au raccord (11) du bobinage une première grandeur électrique devant être mise à disposition par l'appareil de mesure (30), en particulier une tension dans la plage de 0 V jusqu'à quelques kV, comme signal d'essai.

3. Dispositif de commutation selon la revendication 1 ou la revendication 2,
**caractérisé par**
d'autres seconds moyens de commutation (20) commandables, lesquels sont conçus pour prélever d'un raccord (11) associé respectif d'encore un autre bobinage de la pluralité de bobinages une seconde grandeur électrique devant être détectée par l'appareil de mesure (30) comme signal de mesure.

4. Dispositif de commutation selon la revendication 2 et la revendication 3,
**caractérisé en ce**
**que** les autres premiers et seconds moyens de commutation (20) commandables peuvent être commandés par un signal de commande devant être mis à disposition par l'appareil de mesure (30).

5. Dispositif de commutation selon l'une quelconque des revendications 1 à 4,
**caractérisé en ce**
**que** les premiers moyens de commutation (14) commandables sont conçus pour court-circuiter les raccords (11) associés du bobinage du côté secondaire de la pluralité de bobinages avec une résistance ohmique inférieure à 10 Ω, de préférence inférieure à 1 Ω et encore plus préférablement inférieure à 1 mΩ.

6. Dispositif de commutation selon l'une quelconque des revendications 1 à 4,
**caractérisé en ce**
**que** les premiers moyens de commutation (14) commandables sont conçus pour court-circuiter les raccords (11) associés du bobinage du côté primaire de la pluralité de bobinages avec une résistance ohmique de moins de 50 % d'une résistance de bobinage de celui-ci, de préférence inférieure à 1 Ω, et encore plus préférablement inférieure à 1 mΩ.

7. Dispositif de commutation selon l'une quelconque des revendications 1 à 6,
**caractérisé en ce**
**que** les premiers moyens de commutation (14) commandables sont en outre conçus pour court-circuiter deux fois les raccords (11) associés d'un bobinage par l'intermédiaire d'un transformateur.

8. Dispositif de commutation selon l'une quelconque des revendications 1 à 7,
**caractérisé en ce**
**que** les premiers et seconds moyens de commutation (14) commandables peuvent être commandés par un signal de commande devant être mis à disposition par l'appareil de mesure (30).

9. Dispositif de commutation selon l'une quelconque des revendications 1 à 8,
**caractérisé en ce**
**que** la pluralité de bobinages du transformateur comprend au moins un bobinage partiel du transformateur.

10. Dispositif de commutation selon l'une quelconque des revendications 1 à 9,
**caractérisé en ce**
**que** le dispositif de commutation est conçu pour fonctionner avec un transformateur configuré comme convertisseur de tension,
tous les moyens de commutation (14) commandables comprennent de préférence respectivement des interrupteurs de puissance.

11. Dispositif de test pour tester un transformateur, comprenant
le dispositif de commutation (10) selon l'une quelconque des revendications 1 à 10 et l'appareil de mesure (30) pour le transformateur.

12. Dispositif de test selon la revendication 11,
**caractérisé en ce**
**que** l'appareil de mesure (30) est conçu de telle sorte qu'il génère le signal d'essai et le fournit au dispositif de commutation (10), pour appliquer le signal d'essai sur le transformateur par l'intermédiaire du dispositif de commutation (10), et
en ce que l'appareil de mesure (30) est conçu de telle sorte qu'il reçoit un signal de mesure du transformateur par l'intermédiaire du dispositif de commutation (10) et l'évalue.

13. Dispositif de test selon la revendication 12,
**caractérisé en ce**
**que** l'appareil de mesure (30) comprend une source de signaux pour la génération du signal d'essai et une unité d'évaluation pour l'évaluation du signal de mesure,
dans lequel le dispositif de commutation (10) est intégré dans l'appareil de mesure (30).

14. Procédé (50) permettant de faire fonctionner un dispositif de commutation (10) pour un appareil de mesure (30) pour un transformateur, comprenant les étapes :
de court-circuitage de raccords (11) respectifs associés d'un bobinage d'une pluralité de bobinages du transformateur à l'aide de premiers moyens de commutation (14) du dispositif de commutation (10), dans lequel un signal d'essai d'une source de signaux de l'appareil de mesure (30) est fourni à l'un des raccords (11) du bobinage, et
de connexion en série du bobinage à un autre bobinage de la pluralité de bobinages du transformateur à l'aide de seconds moyens de commutation (14, 17, 20) du dispositif de commutation (10).

15. Procédé (50) selon la revendication 14,
dans lequel le procédé est exécuté au moyen du dispositif de commutation (10) selon l'une quelconque des revendications 2 à 10 ou du dispositif de test (40) selon l'une quelconque des revendications 11 à 13.
